# EUROPEAN PATENT APPLICATION

(11) **EP 4 531 418 A1**
(43) Date of publication of application: **02.04.2025**
(21) Application number: 24201213.6
(22) Date of filing: 18.09.2024
(51) Int. Cl.: H04Q 1/02, H05K 7/14

(54) **HIGH-DENSITY DATA CENTER COMPUTER CABINET**

(30) Priority: 19.09.2023 US 202363583619 P
(71) Applicant: Vertiv Corporation, Westerville, OH 43082 (US)
(72) Inventor: O'Fallon, Roy Grantham, Westerville, 43082 (US)
(74) Representative: Cousens, Nico

(57) **Abstract**

The present disclosure is directed to a computer server rack assembly for supporting an electronic unit, per an embodiment. The computer server rack assembly includes a housing, an electric busbar, a first cooling manifold, a second cooling manifold, and at least one rail panel. The housing includes a front space region, a rear space region, a front side, and a back side. The electric busbar is vertically secured to the backside of the server rack and has a power basis of 48 VDC. The first cooling manifold and the second cooling manifolds are vertically secured to the backside of the server rack and are configured to distribute liquid coolant to at least one electronic unit within the housing. The rail panels are configured to be placed within the housing and support an electronic unit within the housing.

## Description

### CROSS-REFERENCE TO RELATED APPLICATION(S)

This application claims the benefit of U.S. Provisional Patent Application No. 63/583,619 filed September 19, 2023.

### BACKGROUND

High-density computer servers are essential components of modern data centers, providing the computational power and storage required for various applications. In order to ensure efficient operation and prevent downtime, the cabinets that house the servers must provide reliable and effective cooling for the servers as well as ensure the safe and efficient distribution of continuous electrical power to the servers.

Conventional server cabinets include four vertical rails with industry standard mounting features to attach and secure the computer servers within the conventional server cabinet. Conventional server cabinets often utilize one or more vertical power distribution units in the rear of the cabinet for power distribution to devices installed within the cabinet. Power distribution units external to the server cabinets can also be used to provide power distribution to devices installed within the cabinet. In addition, conventional server cabinets can utilize one or two liquid cooling manifolds to provide liquid cooling capabilities to high-density servers.

One recent high-density server cabinet implementation inside standard 19-inch server cabinets employs metal housings with power, data, and liquid cooling connections in the rear of the housing. The power and data connections are made with cable harnesses connecting the housing with the power or data devices. There can be a plurality of these housings installed in one server cabinet, with each housing independently connected to the power, data, and liquid cooling elements.

Further, another high-density server cabinet implementation uses a cabinet structure that utilizes horizontal shelves or rails that the computer servers and other devices slide into. One or more DC power devices slide into a shelf and connect to a vertical busbar, located in the rear of the rack and extending the full height of the inside of the rack, thereby supplying the DC power to any device installed in the rack. In addition, there can be one or more liquid cooling manifolds in the rear of the rack that the servers can connect to directly. In these implementations, data is managed in the front of the rack connecting the servers to switches or other management devices, with individual cables.

A common issue with either of these high-density implementations is that they require a substantial investment in infrastructure to employ. This additional infrastructure utilizes high carbon footprint materials. As sustainability becomes increasingly more important when designing data centers, there is a need for a system or method to provide a low carbon footprint design to reduce the total amount of greenhouse gases emitted during the implementation of a high-density computer cabinet. There are currently no solutions available that integrate a rear full height power busbar, multiple cooling manifolds and a full-length network data connection bar into an existing server cabinet.

In light of the above, there exists a need for a high-density computer server cabinet solution that provides reliable power solution, network connectivity, and efficient cooling for the high-density servers therein. The present disclosure provides a solution for this need by introducing a computer server cabinet with horizontal server shelves, allowing for automatic connection to a vertical busbar in the rear and two cooling manifolds in the rear. Further, the disclosure allows for two network connectivity bars in the rear of the cabinet. This novel design overcomes the limitations of conventional computer server cabinets and provides improved power distribution, network connectivity, and cooling capabilities, resulting in enhanced server performance, ease of server maintenance, and reduced downtime.

### BRIEF DESCRIPTION OF DRAWINGS

The detailed description is described with reference to the accompanying figures.
FIG. 1 illustrates a rear view of a server rack assembly including a rack;
FIG. 2 illustrates a rear orthogonal view of the server rack assembly of Fig. 1;
FIG. 3 illustrates an orthogonal view of a vertically oriented coolant distribution unit;
FIG. 4 illustrates an internal view of the vertically oriented coolant distribution unit of Fig. 3;
FIG. 5 illustrates an orthogonal view of a set of rail panels; and
FIG. 6 illustrates a rear orthogonal view of the server rack assembly without a rear mounted coolant distribution unit.

### SUMMARY

This section provides a general summary of the disclosure and is not a comprehensive disclosure of its full scope or all of its features.

In an embodiment, the present disclosure is directed to a computer server rack assembly. The computer server rack assembly includes a housing. The housing can be made of a steel or timber material. The housing includes a front space region, a rear space region, a front side, and a back side, wherein the front side and back side oppose each other. The width of the front side of the computer server rack assembly is 19 inches (48.26 cm). The computer server rack assembly further includes an electric busbar vertically secured to the back side of the server rack, wherein the electric busbar is configured to distribute power from an electric grid to one or more electronic computing devices.

The computer server rack assembly further includes a first cooling manifold and a second cooling manifold. The cooling manifolds are vertically secured to the back of the server rack and are configured to distribute coolant to one or more electronic computing devices. To provide coolant to the cooling manifolds, the computer server rack assembly further includes a coolant distribution unit. The coolant distribution unit can be mounted between the front side and the back side of the computer server rack assembly. To enable efficient connection between the coolant distribution unit and the first and second cooling manifolds, the cooling manifolds are equipped with quick disconnects.

The electric busbar of the computer server rack assembly has a power basis of 48 VDC and is sized to enable complete and efficient power delivery to one or more electronic computing devices within the computer server rack assembly.

The computer server rack assembly further includes rail panels to accommodate simple insertion and removal of electronic computing devices within the computer server rack assembly. The vertical size of the rail panels are in 6 rack unit increments.

The computer server rack assembly further includes a first vertical data connection bar and a second vertical data connection bar. The first vertical data connection bar and the second vertical data connection bar can be mounted to the back side of the computer server rack assembly to allow the electronic computing devices to connect to a network.

These and other features and aspects may be better understood with reference to the following drawings, description, and appended claims.

### DETAILED DESCRIPTION

Aspects of the disclosure are described more fully hereinafter with reference to the accompanying drawings, which form a part hereof, and which show, by way of illustration, example features. The features can, however, be embodied in many different forms and should not be construed as limited to the combinations set forth herein; rather, these combinations are provided so that this disclosure will be thorough and complete and will fully convey the scope. The following detailed description is, therefore, not to be taken in a limiting sense.

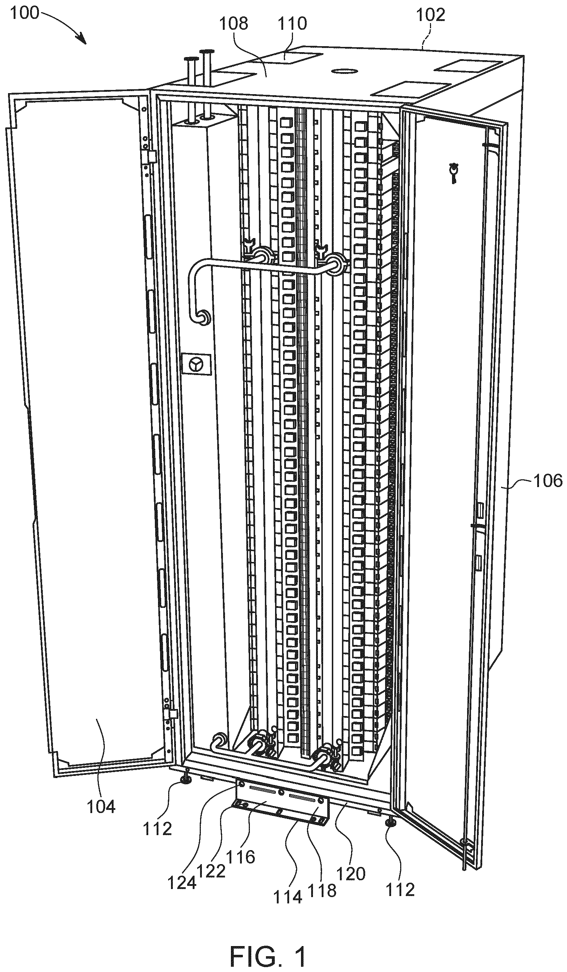

Shown throughout the figures, the present disclosure is directed towards a computer cabinet assembly that utilizes a number of modular features to enhance power, networking, and cooling capabilities. Referring initially to FIG. 1, a computer cabinet 100 is illustrated in accordance with an exemplary embodiment of the present disclosure.

FIG.1 is a rear orthogonal view illustrating a computer cabinet 100 in an open position according to one embodiment of the present disclosure. The computer cabinet 100 includes a front door 102, at least one rear door 104, at least one side panel 106, and a top panel 108. The computer cabinet 100 can include at least one top opening 110 formed in the top panel 108 that can accommodate input and exhaust features of components housed within computer cabinet 100. The computer cabinet 100 can include risers 112 to separate the computer cabinet 100 from the ground. The risers 112 can elevate the computer cabinet 100 any distance from the ground. Further, all of the risers 112 do not need to be the same distance from the ground. For example, the risers 112 can be different distances from the ground to ensure that the computer cabinet 100 is level if the ground is not level. Further, the risers 112 can be different distances to the ground to achieve optimal airflow or clearance beneath the computer cabinet 100 As shown in an exemplary embodiment, the risers 112 can be located at each corner of the computer cabinet 100.

In an exemplary embodiment, the computer cabinet 100 can further include a stabilizing plate 114 that allows the computer cabinet 100 to be securely fastened to the floor. For example, the stabilizing plate 114 can improve stability by anchoring the computer rack 100 to a fixed point on the floor surface. Certain regulatory requirements can require the use of a stabilizing unit, such as the stabilizing plate 114 as depicted, that prevents a cabinet from tipping over in response to unwanted forces such as seismic force, inadvertent contact by a person, or forces applied when making changes within or around the computer cabinet 100. The stabilizing plate 114 includes a horizontal base plate 116 and a vertical base plate 118 attached to a base 120 of the computer cabinet 100. The horizontal base plate 116 can include a number of floor mounting holes 122. The vertical plate 118 can include a number of cabinet mounting holes 124. In an embodiment, the floor mounting holes 122 can facilitate the use of fasteners to affix the computer rack 100 to a fixed point on the ground or on a structure fixed to the ground. In an embodiment, the cabinet mounting holes 124 can facilitate the use of fasteners to affix the stabilizing plate 114 to the base 120 of the computer cabinet 100.

In an exemplary embodiment, the computer cabinet 100 can be made out of a metallic material, such as steel or aluminum. However, in an alternative embodiment, the computer cabinet 100 and internal support structures can be constructed using one or more low carbon footprint materials. For example, the computer cabinet 100 can be formed of a timber material (e.g., a wood material that is suitable for construction). In one instance, the timber material may incorporate, in whole or in part, any suitable wood material (e.g., a material derived from a tree, bamboo, or another woody plant). In another instance, the timber material may incorporate, in whole or in part, a timber-based composite.

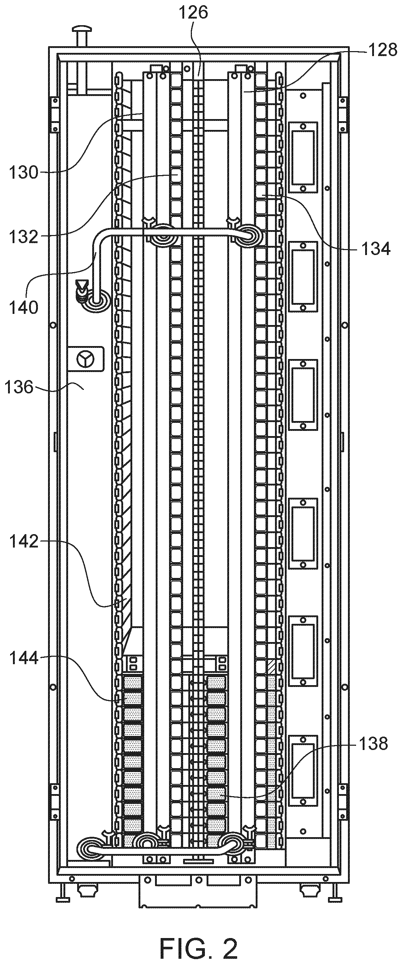

Fig. 2 is a rear view illustrating the computer cabinet 100 according to one embodiment of the present disclosure. Depicted in Fig. 2 is a vertical busbar 126, a first cooling manifold 128, a second cooling manifold 130, a first vertical networking bar 132 and a second vertical networking bar 134.

FIG. 2 also illustrates a vertical busbar 126. In an exemplary embodiment, the vertical busbar 126 is located centrally between each of the side panels 106 and can extend from the top panel 108 down to the base 120. The vertical busbar 126 can be made of a material that can effectively conduct electricity to power several electronic devices. Examples of such a material can include copper and aluminum. The vertical busbar 126 is attached to the computer cabinet 100 via a connector between the vertical busbar 126 and the top panel 108, and the vertical busbar 126 and the base 120.

FIG. 2 further illustrates a coolant distribution unit (CDU) 136 located within the interior of the computer cabinet 100. As shown in an exemplary embodiment, the CDU 136 is located in the rear space 138 of the computer cabinet 100, close to the rear door 104. It is to be understood that while, in the exemplary embodiment, the CDU 136 is located within the interior of the computer cabinet 100 in a vertical orientation, the CDU 136 can also be placed on the outside of the computer cabinet 100 or within the computer cabinet 100 in a horizontal orientation.

FIG. 2 further illustrates a first cooling manifold 128 and a second cooling manifold 130. In an embodiment, the manifolds 128, 130 can carry coolant to and from the CDU 136 to cool electronic systems within the computer cabinet 100. The CDU 136 can be connected to the manifolds 128, 130 via a tubing 140. In an embodiment, the tubing 140 can be a rigid pipe, while in another embodiment the tubing 140 can be a flexible hose. There further exists an array of couplings down the vertical length of the manifolds 128, 130 by which the electronic equipment within the computer cabinet 100 can be fluidly coupled with the CDU 136. In some embodiments, the CDU 136 is configured to minimize condensation. Buildup of condensation within the interior or the exterior of the CDU 136 can cause damage or failure to the CDU 136 or any piece of equipment within the computer cabinet 100, and therefore should be minimized. In some embodiments, the CDU 136 can include different types of pumps depending on the size and flow rate requirements. For example, the CDU 136 can include a centrifugal pump or a positive displacement pump.

Further, FIG. 2 illustrates a server rack 142 that is housed within the interior of the computer cabinet 100. The server rack 142 is capable of securely holding rack mountable systems 144. A rack mountable system 144, can, by way of example, be a server blade, a power supply unit, a keyboard, video, and mouse (KVM) switch, or a network patch panel. In addition, the rack mountable systems 144 can be secured to the server rack 142 in a repeatable fashion that presents components in a known, repeatable fashion. For example, the rack mountable system 144 can include a coupling from the rear portion of the system that is presented in a known, repeatable fashion by virtue of the method of mounting the rack mountable system 144 to the server rack 142. In this way, the rack mountable system 144 can be connected to the first cooling manifold 128 and/or the second cooling manifold 130 via a coupling to allow coolant distributed from the CDU 136 to cool the rack mountable systems 144. In addition, the rack mountable system 144 can include networking and power cables extending from the rear in a known, repeatable fashion, allowing for simpler and safer cable replacement or repair. For example, a network switch mounted within the computer cabinet 100 can present a repeatable set of network port interfaces that cabling can be inserted into. Additionally, a computer server mounted within the computer cabinet 100 can present a repeatable set of power ports, networking ports, and cooling ports that cabling can connect to. This allows for easier removal and maintenance of the devices that sit within the computer cabinet 100.

FIG. 2 further illustrates a first vertical networking bar 132 and a second vertical networking bar 134. In an exemplary embodiment, the first vertical networking bar 132 is located proximate to the first cooling manifold 128, and the second vertical networking bar 134 is located proximally to the second cooling manifold 134. The vertical networking bars 132, 134 can attach to the rear of computer cabinet 100 via a connector between the vertical networking bars 132, 134 and the top panel 108, and the vertical networking bars 132, 134 and the base 120.

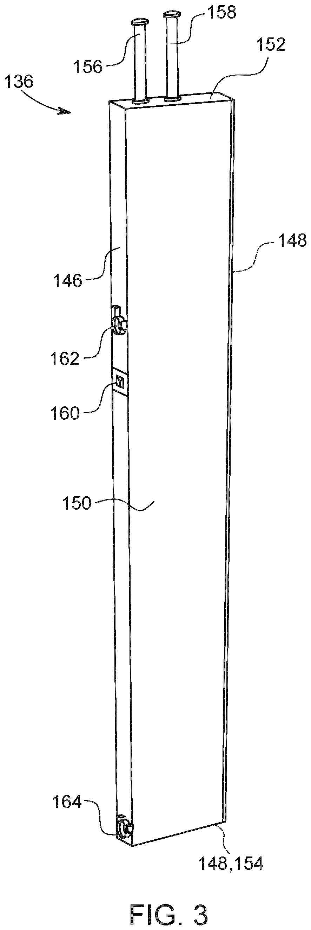

FIG. 3 illustrates a CDU 136. The CDU 136 can include a front panel 146, a rear panel 148, at least one side panel 150, a top panel 152, and a bottom panel 154 that cooperate to define a housing for CDU 136. The panels 146, 148, 150, 152, and 154 can be constructed with sheet metal or a composite material. As depicted in the exemplary embodiment, the vertical distance from the top panel 152 to the bottom panel 154 is greater than the horizontal distance from the front panel 146 to the rear pane 148. The CDU 136 can further include an intake conduit 156 and an exhaust conduit 158. As depicted, the conduits 156, 158 connect the interior of the CDU 136 to the exterior through top panel 152.

FIG. 3 further illustrates that, in an exemplary embodiment, the CDU 136 includes a human machine interface (HMI) 160 located on the front panel 146. The HMI 160 can be connected to the electric control system of the CDU 136. The HMI 160 is capable of allowing user input to control features of the CDU 136 such as coolant flow rates, coolant flow pressures, or turning the CDU 136 on and off. Further, the HMI 160 is capable of displaying critical information related to the operation of the CDU 136, such as warnings, alarms, and temperature information of the coolant and the electronic systems within the cabinet 100. However, it is to be understood that the HMI 160 can be configured to display any information captured by CDU 136 during its operation. The CDU 136 can also include a logo plate. It is further contemplated that the CDU 136 can include both an HMI and logo plate in the same location on the computer cabinet 100.

FIG. 3 further shows an upper manifold connection point 162 and a lower manifold connection point 164. The upper manifold connection point 162 can be positioned on the front panel 146 proximate to the top panel 152 of the CDU 136. The lower manifold connection point 164 can be positioned on the front panel 146 proximal to the bottom panel 154 of the CDU 136. In an embodiment, the tubing 140 can be connected to the CDU 136 at the upper manifold connection point 162 and connected to the rack. The tubing 140 is configured to carry cooled coolant from the CDU 136 to the rack manifold in order to absorb the heat produced by the electronic systems therein. In an exemplary embodiment, the electronic systems therein can include a uniform coupling extending from the rear portion, allowing for consistent attachment point to the rack manifold. Further, a tubing can be connected to the rack manifold and the lower manifold connection point 164. The tubing 140 is configured to carry warmed coolant from the rack manifold 128, 130 to the CDU 136. It is to be understood that the tubing 140 used to carry coolant from the CDU 136 to the rack and from the rack to the CDU 136 can be a hose or a pipe and can be rigid or flexible. A rigid hose or rigid pipe can make it easier for a user to effectively organize cables extending from the rear of the computer cabinet 100. It is also to be understood that the length of the tubing 140 can be any length required to comfortably connect the CDU 136 to the computer cabinet 100.

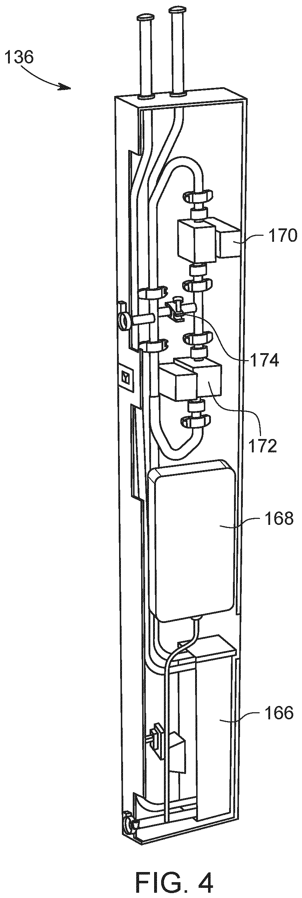

FIG. 4 illustrates an interior view of a CDU 136 in accordance with the exemplary embodiment. The CDU 136 can consist of a heat exchanger 166, an expansion tank 168, an upper pump 170, a lower pump 172, and a control valve 174. In an exemplary embodiment, the lower pump 172 acts chiefly as a redundant, backup pump in case upper pump 170 malfunctions. In an embodiment, the heat exchanger 166 is a brazed plate heat exchanger. It is to be understood, however, that the heat exchanger 166 can be any type of plate exchanger. The heat exchanger 166 can be located proximate to the rear panel 148 and bottom panel 154 of the CDU 136. The intake conduit 156 receives coolant from an external source and passes the coolant through the CDU 136 until the coolant exits via a tubing 140 to the first or second cooling manifold 128, 130. The exhaust conduit 158 takes used coolant from the manifold 128, 130 that passes through the heat exchanger 166 to a location outside of the CDU 136 to be recycled and used again as coolant once the heat has been removed from the coolant.

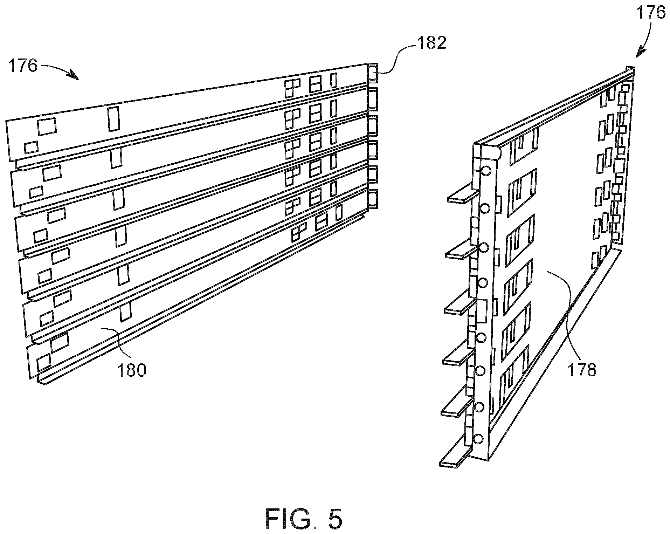

FIG. 5 illustrates a pair of rail panels 176. A rail panel 176 can include an external side 178 and an internal side 180. A rail panel 176 may be manufactured using stamped metallic pieces made out of a larger piece of sheet metal. As shown in the exemplary embodiment, a rail panel 176 is configured to enclose 6 units of rack space in a computer cabinet 100. The rail panel 176 can have an end clip 182 that enables a user to attach the rail panel 176 to the computer cabinet 100 without any tools. The end clip 182 further allows a user to remove the rail panel 176 from the computer cabinet 100 without any tools. It is to be understood that while the rail panel 176 allows a user to install a variety of rack devices within the computer cabinet 100, a user may also choose to not install a rail panel 176 and instead install traditional rack devices that would otherwise not fit within a rail panel 176.

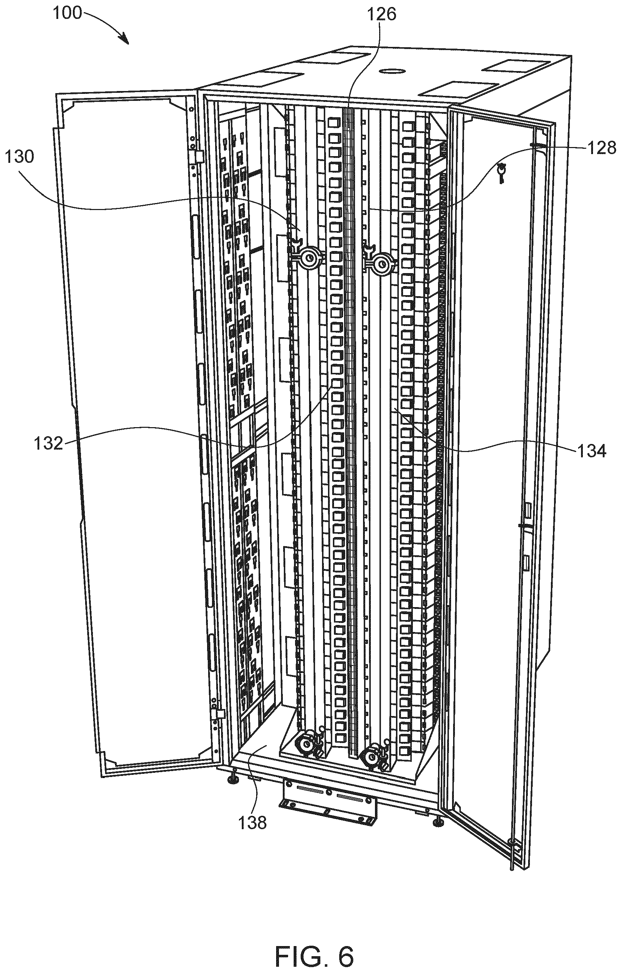

FIG. 6 is a rear orthogonal view of the computer cabinet 100 that does not have a rear mounted CDU 136. In an embodiment, the cooling requirements of the rack mountable systems 144 can be met using other cooling mechanisms, including, but not limited to, in-row cooling units, computer room air conditioners, computer room air handlers, or free cooling systems. The exemplary embodiment includes a first cooling manifold 128 and a second cooling manifold 130 that can handle coolant from cooling systems outside of the computer cabinet 100.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A computer server rack assembly comprising:
a housing comprising a front space region, a rear space region, a front side, and a back side opposite to the front side, wherein the housing defines a front space region and a rear space region;
an electric busbar vertically secured to the back side of the housing, wherein the electric busbar is configured to distribute power from a power source to one or more electronic computing devices;
a first cooling manifold extending at least partially vertically and secured to the back side of the housing, wherein the first cooling manifold is configured to distribute coolant to at least one of the one or more electronic computing devices;
a second cooling manifold extending at least partially vertically and secured to the back side of the housing, wherein the second cooling manifold is configured to distribute coolant to at least one of the one or more electronic computing devices; and
a plurality of rail panels disposed within the front and back sides of the housing and configured to support the one or more electronic computing devices.

2. The computer server rack assembly of claim 1, further comprising a coolant distribution unit disposed between the front side and back side of the housing.

3. The computer server rack assembly of claim 1 or 2, wherein a width of the front side is about 48 centimeters.

4. The computer server rack assembly of any preceding claim, wherein the electric busbar is configured to supply about 48 VDC.

5. The computer server rack assembly of any preceding claim, wherein each of the first cooling manifold and the second cooling manifold comprises a quick disconnect.

6. The computer server rack assembly of claim 2 or any preceding claim when dependent on claim 2, wherein the coolant distribution unit extends at least partially vertically and disposed within the rear space region.

7. The computer server rack assembly of any preceding claim, wherein the first cooling manifold and second cooling manifold are on opposite sides of the electric busbar.

8. The computer server rack assembly of any preceding claim, wherein the plurality of rail panels are spaced in 6 rack unit increments.

9. The computer server rack assembly of any preceding claim, further comprising a first vertical data connection bar secured to the back side of the housing.

10. The computer server rack assembly of claim 9, further comprising a second vertical data connection bar secured to the back side of the housing.

11. The computer server rack assembly of any preceding claim, further comprising a power shelf configured to supply power from the power source to the electric busbar.

12. A computer server rack assembly comprising:
a housing configured to support one or more electronic computing devices;
a power distribution system secured to the housing and configured to distribute power to the one or more electronic computing devices; and
a cooling system secured to the housing, wherein the cooling system is configured to distribute coolant to the one or more electronic computing devices.

13. The computer server rack assembly of claim 12, wherein the cooling system distributes coolant to the one or more electronic computing devices via a manifold system.

14. The computer server rack assembly of claim 13, wherein the manifold system is secured to the housing.

15. The computer server rack assembly of any of claims 12 to 14, further comprising a coolant distribution unit disposed between a front side and a back side of the server rack assembly.
